# EUROPÄISCHE PATENTSCHRIFT

(11) **EP 1 206 704 B1**
(45) Veröffentlichungstag und Bekanntmachung des Hinweises auf die Patenterteilung: **13.08.2003**
(21) Anmeldenummer: 00960437.2
(22) Anmeldetag: 10.08.2000
(51) Int. Cl.: G01R 1/067, G01R 1/073

(54) **PRÜFNADEL FÜR EINEN RASTERANPASSUNGSADAPTER EINER VORRICHTUNG ZUM TESTEN VON LEITERPLATTEN**
TEST NEEDLE FOR A RASTER-MATCHING ADAPTER AND A DEVICE FOR TESTING PRINTED CIRCUIT BOARDS
AIGUILLE DE TEST POUR ADAPTATEUR DE QUADRILLAGE D'UN DISPOSITIF SERVANT A TESTER DES CARTES DE CIRCUITS

(30) Priorität: 23.08.1999 DE 19939955
(43) Veröffentlichungstag der Anmeldung: 22.05.2002
(73) Patentinhaber: ATG TEST SYSTEMS GmbH & Co. KG, 97877 Wertheim (DE)
(72) Erfinder: PROKOPP, Manfred, 97877 Wertheim-Reicholzheim (DE); OTT, Bernd, 74405 Gaildorf (DE)
(74) Vertreter: Ganahl, Bernhard
(86) Internationale Anmeldenummer: EP0007793
(87) Internationale Veröffentlichungsnummer: WO01014893

(56) Entgegenhaltungen:
- EP-A- 0 495 380
- DE-A- 3 620 947
- US-A- 4 896 107
- US-A- 4 899 104

## Beschreibung

Die Erfindung betrifft eine Prüfnadel für einen Rasteranpassungsadapter einer Vorrichtung zum Testen von Leiterplatten.

Mit derartigen Rasteranpassungsadaptern wird ein vorbestimmtes, regelmäßiges Grundraster einer Prüfvorrichtung auf die üblicherweise unregelmäßige Anordnung der Leiterplattentestpunkte einer zu testenden Leiterplatte umgesetzt. Der Rasteranpassungsadapter weist in der Regel mehrere voneinander beabstandete Führungsplatten auf, in welchen Führungslöcher zur Aufnahme der Prüfnadeln eingebracht sind. Die Prüfnadeln sind im Adapter schräg angeordnet, so daß sie Kontaktpunkte des regelmäßigen Grundrasters mit den Leiterplattentestpunkten elektrisch verbinden können, da diese in der Regel von der regelmäßigen Anordnung des Grundrasters abweichen.

Da die Leiterplattentestpunkte mit immer kleineren Abständen auf den Leiterplatten angeordnet werden, die beispielsweise nur noch 0,3 mm (12 mil) bzw. 0,25 mm (10 mil) betragen, müssen die Prüfnadeln an der zum Prüfling weisenden Seite des Adapters entsprechend eng beieinander liegend angeordnet werden.

Für derartige Adapter verwendet man deshalb extrem dünne Nadeln, die beispielsweise nur einen Durchmesser von 0,1 mm oder 0,2 mm aufweisen. Diese Nadeln sind aber äußerst instabil, so daß viele Führungsplatten im Adapter vorgesehen werden müssen, um sie sicher führen zu können.

Ferner sind Prüfnadeln bekannt, die Bereiche unterschiedlicher Durchmesser aufweisen, wobei zwischen einzelnen Bereichen jeweils ein stufenförmiger Übergang ausgebildet ist. Der an die mit einem Leiterplattentestpunkt der zu prüfenden Leiterplatte zu kontaktierende Kontaktspitze angrenzende Bereich der Nadel weist den geringsten Durchmesser auf, der dann stufenweise mit zunehmendem Abstand von der Kontaktspitze erhöht wird. Diese abgestuften Nadeln besitzen gegenüber dünnen Nadeln eine wesentlich größere Steifigkeit und können mit ihren Kontaktspitzen auch relativ eng nebeneinander liegend angeordnet werden. Der an die Kontaktspitze angrenzende Bereich ist jedoch auch sehr labil, so daß er im Rasteranpassungsadapter durch mehrere Prüfplatten abgestützt werden muß.

In dem Gebrauchsmuster DE 91 00 432 U1 bzw. in der korrespondierenden europäischen Patentanmeldung EP 0 495 380 A wird eine Tastnadel für einen elektrischen Prüfadapter offenbart. Die Nadel ist an dem freien Ende kegelförmig zugespitzt. Die Spitze weist eine kugelartige Rundung mit einem Radius von ungefähr 50 µm auf. Dieses Gebrauchsmuster lehrt als Radius der kugelartigen Spitze einen Bereich von 20 bis 80 µm.

In der US 4,896,107 sind Prüfstifte dargestellt, deren Prüfspitze kegelförmig spitz zuläuft und die an dem von der Prüfspitze entfernten Ende einen kugelförmigen Kopf aufweisen. Der größte Schaftdurchmesser d dieser Prüfstifte beträgt 1,3 bis 1,4 mm und der Durchmesser D des Kopfes beträgt etwa 2 mm.

Das Gebrauchsmuster DE 298 10 384 U1 zeigt konisch spitz zulaufende Nadeln. Die Dicke der Nadeln ist nicht beschrieben.

In der DE 37 36 689 A1 und der DE 36 39 360 A1 sind Prüfstifte dargestellt, deren Prüfspitze kegelförmig spitz zuläuft und die an dem von der Prüfspitze entfernten Ende einen kugelförmigen Kopf aufweisen. Der größte Schaftdurchmesser dieser Nadeln beträgt 1,3 bis 1,4 mm und der Durchmesser des Kopfes beträgt etwa 2 mm. Der Durchmesser der Kontaktspitze ist nicht offenbart.

Die DE 44 17 811 A1 zeigt Prüfstifte, die eine sehr kurze konische Spitze zum Kontaktieren einer Kontaktstelle besitzen.

Die DE 44 39 758 A1 offenbart einen Prüfstift für einen Prüfadapter, der wiederum eine kurze konisch ausgebildete Spitze aufweist. Die Spitze wird durch Schleifen hergestellt. Diese Entgegenhaltung zeigt einen Adapter mit teilweise schräggestellten Prüfnadeln.

Die DE 36 20 947 A1 zeigt eine aus einem Draht mit konstanten Querschnitt bestehende Prüfspitze, deren Durchmesser weniger als 0,2 mm beträgt. Zudem ist eine weitere spitz zulaufende Nadel gezeigt.

Die US 4,403,822 zeigt eine spitz zulaufende Prüfnadel. Die Dicke dieser Prüfnadel ist nicht angegeben.

Die DE 44 29 758 C2 beschreibt Prüfstifte aus einem dünnen Draht mit einer Dicke von 0,15 mm bis 0,5 mm. Diese Prüfstifte sind mit einer kurzen Spitze versehen.

Die DE 196 54 404 A1 zeigt eine sehr aufwändige Lösung zum Testen von Leiterplatten mit einem Pitch-Abstand von 200 um. Hierbei wird ein Adapter mit Prüfnadeln mittels einer Translatorfolie mit den sehr eng beieinanderliegenden Kontaktpunkten kontaktiert. Diese Anmeldung zeigt deutlich, dass es nicht ohne weiteres möglich ist, eng beieinander liegende Kontaktpunkt zu kontaktieren.

Die DE 43 23 276 A1 zeigt die Verwendung von glatten, konturlosen "music wire" Prüfstiften in einem Adapter. Bei diesem Adapter wird ein Vollmaterialkörper vorgesehen, der von durchgehenden Prüfstiftkanälen durchsetzt ist, in welchen die dünnen Prüfstifte sicher geführt sind. Diese Prüfstifte können einen Durchmesser bis zu 0,1 mm besitzen.

Das Gebrauchsmuster DE 296 16 272 U1 offenbart einen Adapter mit interner Verstelleinrichtung.

Der Erfindung liegt die Aufgabe zugrunde, eine Prüfnadel für ein Rasteranpassungsadapter einer Vorrichtung zum Testen von Leiterplatten zu schaffen, die bezüglich der Stabilität und zum Erzielen eines minimalen Abstandes der Prüfspitzen zweier benachbarter Prüfnadeln in einem Rasteranpassungsadapter optimal ausgebildet ist.

Die Erfindung wird durch eine Prüfnadel mit den Merkmalen des Anspruchs 1 gelöst. Vorteilhafte Ausgestaltungen der Erfindung sind in den Unteransprüchen angegeben.

Die Erfindung betrifft and einen Rasteranpassungsadapter nach Anspruch 11.

Die erfindungsgemäße Prüfnadel für einen Rasteranpassungsadapter einer Vorrichtung zum Testen von Leiterplatten zeichnet sich dadurch aus, daß die Nadel einen sich zu einer freien Kontaktspitze der Nadel konisch verjüngend ausgebildeten Kontaktbereich zum Kontaktieren eines Leiterplattentestpunktes aufweist, wobei der Kontaktbereich eine Länge von zumindest 20 mm und an der Kontaktspitze einen Durchmesser von kleiner 0,2 mm besitzt, und daß ein der Kontaktspitze gegenüberliegender Endabschnitt des Kontaktbereichs einen Durchmesser im Bereich von 0,3 mm bis 0,4 mm aufweist.

Der sich zur Kontaktspitze konisch verjüngende Kontaktbereich stellt den optimalen Ausgleich zwischen sehr dünnen Nadeln, die zum Kontaktieren sehr eng beieinander liegender Leiterplattentestpunkte geeignet sind, und dickeren Nadeln, die eine größere Stabilität aufweisen und hierdurch einfacher in einem Rasteranpassungsadapter, das heißt, mit weniger Führungsplatten geführt werden können.

Da sich der Querschnitt der erfindungsgemäßen Nadel unmittelbar im Bereich hinter der Kontaktspitze erweitert, ist der Kontaktbereich wesentlich steifer als bei Prüfnadeln mit einer genauso kleinen Kontaktspitze aber bekanntem Durchmesser im Kontaktbereich. Dies gilt auch im Vergleich mit den eingangs beschriebenen, abgestuft ausgebildeten Prüfnadeln, deren dünnster, die Kontaktspitze aufweisender Abschnitt, wesentlich biegsamer als der Kontaktbereich der erfindungsgemäßen Nadel bei gleichem Durchmesser an der Kontaktspitze ist. Es hat sich gezeigt, daß in einem Adapter mit den erfindungsgemäßen Prüfnadeln in der Regel eine Führungsplatte gegenüber einem Adapter mit abgestuften Prüfnadeln eingespart werden kann.

Die Erfindung wird nachfolgend näher anhand der Zeichnung erläutert, in der zeigen:
- Fig. 1: eine Prüfnadel gemäß der Erfindung in einer vergrößerten Darstellung und mit vom tatsächlichen Ausführungsbeispiel abweichenden Proportionen, und
- Fig. 2: schematisch vereinfacht den Aufbau eines Adapters mit den erfindungsgemäßen Prüfnadeln.

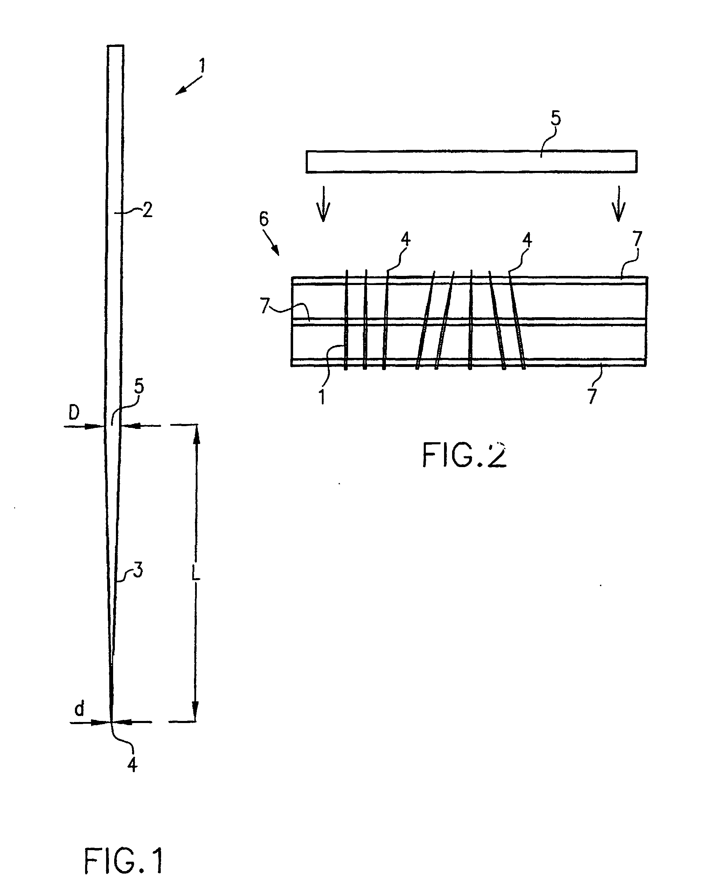

Das in Fig. 1 gezeigte Ausführungsbeispiel einer erfindungsgemäßen Prüfnadel 1 weist einen Basisbereich 2 und einen sich daran anschließenden Kontaktbereich 3 auf. Der Basisbereich 2 ist ein stabförmiger Abschnitt mit kreisförmigen Querschnitt und konstantem Durchmesser D und der Kontaktbereich 3 ist zu seinem freien Ende hin konisch verjüngt ausgebildet, so daß er an seinem freien Ende eine Kontaktspitze 4 bildet. Der der Kontaktspitze 4 gegenüberliegende Endabschnitt 5 des Kontaktbereichs 3 besitzt den gleichen Durchmesser D wie der Basisbereich 2. Der Durchmesser d der Prüfnadel an der Kontaktspitze 4 ist kleiner oder gleich 0,2 mm und beträgt vorzugsweise 0,1 mm, damit eng beieinander liegende Leiterplattentestpunkte einer zu prüfenden Leiterplatte kontaktiert werden können.

Zum Prüfen einer zu testenden Leiterplatte 5 sind die Prüfnadeln 1 in einem Rasteranpassungsadapter 6 (Fig. 2) angeordnet, mit welchem ein regelmäßiges Grundraster einer Prüfvorrichtung auf die unregelmäßige Anordnung der Leiterplattentestpunkte umgesetzt wird, indem die Prüfnadeln 1 im Adapter 6 schräggestellt sind. Insbesondere ist es mit einem solchen Rasteranpassungsadapter 6 möglich, daß viele eng beieinander liegende Leiterplattentestpunkte getestet werden können, indem eine entsprechende Anzahl von Prüfnadeln 1, die einen größeren Bereich des Grundrasters abdecken, auf diesen Bereich der eng beieinander liegenden Leiterplattentestpunkte gerichtet werden. Diese Prüfnadeln 1 sind somit ähnlich wie bei einem Strahlenbündel auf diese eng beieinander liegenden Leiterplattentestpunkte fokusiert.

Die Prüfnadeln 1 werden im Rasteranpassungsadapter 6 durch voneinander beabstandete Führungsplatten 7 gehalten, in welche Führungsbohrungen eingebracht sind, durch die sich die Prüfnadeln 1 erstrecken.

Der minimale Abstand zwischen den Kontaktspitzen 4 benachbarter Prüfnadeln 1 kann nicht beliebig verringert werden, da die Führungslöcher nicht beliebig eng aneinanderliegend gebohrt werden können und zudem beim Bohren Bohrstege entstehen, die einen gewissen Abstand verursachen. Diese Beschränkungen müssen bei der Festlegung der Maße der erfindungsgemäßen Prüfnadel berücksichtigt werden. Ferner hat das Grundraster der Prüfvorrichtung erheblichen Einfluß auf die räumliche Anordnung der Prüfnadeln, und da die Prüfnadeln im Rasteranpassungsadapter nicht beliebig schräg gestellt und gedreht werden können, auch auf den minimalen Abstand der Prüfspitzen, da sich die Prüfnadeln sonst berühren würden.

Aufgrund der raumlichen Anordnung der Prüfnadeln im Rasteranpassungsadapter ist es nicht möglich, relativ dicke Prüfnadeln mit lediglich einer kleinen, kurzen Spitze vorzusehen da diese Nadeln wegen der entsprechend größeren Bohrlöcher nicht eng nebeneinander liegend angeordnet werden können und zudem die Gefahr besteht, daß sie sich mit den an den Kontaktspitzen angrenzenden Bereichen berühren. Bei den erfindungsgemäßen Nadeln werden diese Probleme durch die sich allmählich über eine vorbestimmte Länge L konisch erweiternden Kontaktbereiche vermieden.

Bei Prüfvorrichtungen zum Prüfen von unbestückten Leiterplatten werden das sogenannte Single-Density-Raster und das Double-Density-Raster eingesetzt. Das Single-Density-Raster ist ein 1/10 Zoll-Raster, das Kontaktpunkte aufweist, die nach einem rechtwinkligen Koordinatensystem mit einem Kontaktpunktabstand in beiden Koordinatenrichtungen von a=1/10 Zoll = 2,54 mm versetzt sind. Das Double-Density-Raster unterscheidet sich vom Single-Density-Raster dadurch, daß es durch ein identisches weiteres Kontaktpunktraster überlagert ist, das gegenüber dem Ausgangsraster in beiden Koordinatenrichtungen um 0,5a verschoben ist. Das Double-Density-Raster ist in der EP 0 222 036 B1 beschrieben.

Mit Computerrechnungen kann die minimale Länge L des Kontaktbereichs 3 auf Grundlage des Grundrasters, des Durchmessers D im Basisbereich 2, des Durchmessers d an der Kontaktspitze 4, der Gesamtlänge der Prüfnadel und dem Bohrdurchmesser für einen vorgegebenen Mindestabstand zweier benachbarter Kontaktspitzen 4 eines Rasteranpassungsadapters bestimmt werden.

Für derartige Beispielrechnungen wird von einer Prüfnadel mit einer Gesamtlänge von ca. 95 mm und einer Kontaktspitze mit einem Durchmesser von d gleich 0,1 mm ausgegangen. Der Bohrdurchmesser beträgt einschließlich eines Bohrsteges 0,15 mm.

Für diese Beispielrechnungen sind in der unten angegebenen Tabelle die minimalen Längen L des Kontaktbereichs 3 für unterschiedliche Dicken D (0,3 mm bzw. 0,4 mm) und unterschiedliche Grundraster der Prüfvorrichtung zum Erzielen eines Abstandes zwischen den Kontaktspitzen von 0,3 mm (= 12 mil). angegeben. Als Grundraster der Prüfvorrichtung werden den Beispielrechnungen das oben beschriebene Single-Densitiy-Raster SD und das Double-Density-Raster DD zugrunde gelegt.

Bei vier der Beispielrechnungen ist zusätzlich am Prüfling 5 ein Raster der Leiterplattentestpunkte mit 20 x 20 Leiterplattentestpunkte vorgesehen, die bei zwei Beispielrechnungen zudem gegenüber dem Grundraster um 45° gedreht angeordnet sind. Derartige eng beieinander liegende Leiterplattentestpunkte werden mittels sogenannter Ballgridarrays auf den Leiterplatten realisiert. Diese Ballgridarrays stellen Bereiche mit extrem hoher Dichte von Leiterplattentestpunkten dar.

Die Beispielrechnungen wurden mit zwei Methoden M1, M2 zur Anordnung der Prüfnadeln gerechnet. Bei der Methode M1 wurde jede theoretisch mögliche Schrägstellung der Prüfnadeln berücksichtigt. Bei der Methode M2 wird von einer optimierten Anordnung der Prüfnadeln ausgegangen. Eine solche optimierte Anordnung von Prüfnadeln kann mittels spezieller Computerprogramme erhalten werden, die bei der Herstellung von Rasteranpassungsadapter eingesetzt werden. Durch die Optimierung der Anordnung wird die maximale Schrägstellung der Prüfnadeln im Rasteranpassungsadapter verringert.

Die Beispielrechnungen ergeben, daß bei einem Single-Density-Raster und einer Prüfnadel mit einer Dicke D von 0,3 mm die Länge des Kontaktbereichs 15 mm sein kann. Für die übrigen Beispielrechnungen ist die minimale Länge des Kontaktbereichs 3 gleich oder größer als 20 mm. Je größer die Länge des Kontaktbereiches ist, desto geringer ist die Zunahme des Durchmessers von der Kontaktspitze 4 in Richtung zum Endabschnitt 5 des Kontaktbereichs 3. Mit der optimierten Methode zum Anordnen der Prüfnadeln M2 wird die maximale Schrägstellung der Prüfnadeln verringert, wodurch die Länge L des Kontaktbereichs entsprechend verringert werden kann.

**Tabelle zur Berechnung von L**

| Grundraster | Methode | D | L | Anmerkung |
|---|---|---|---|---|
| SD | M1 | 0,3 | 15 | |
| DD | M1 | 0,3 | 20 | |
| DD | M2 | 0,3 | 20 | 20 x 20 |
| DD | M2 | 0,3 | 30 | 20 x 20 gedreht |
| SD | M1 | 0,4 | 30 | |
| DD | M1 | 0,4 | 40 | |
| DD | M2 | 0,4 | 25 | 20 x 20 |
| DD | M2 | 0,4 | 45 | 20 x 20 gedreht |

Bei einem Durchmesser D von 0,3 mm der Prüfnadel und einem Durchmesser von 0,1 mm an der Kontaktspitze können mit einer Länge von 30 mm ein Feld von Leiterplattentestpunkten abgegriffen werden, die jeweils einen Abstand von 0,3 mm besitzen, wobei die Leiterplattentestpunkte nicht bezüglich des Grundrasters ausgerichtet sein müssen. Eine derartige Nadel genügt deshalb den zur Zeit bestehenden Anforderungen an das Testen von Feldern mit dicht beieinander liegenden Leiterplattentestpunkten. Bei einem Durchmesser D von 0,4 mm können mit einer Länge L von 45 mm des Kontaktbereichs derartige Felder von Leiterplattentestpunkten sicher abgetastet werden.

Die obigen Beispielrechnungen beruhen auf Parameter, wie z.B. dem Bohrdurchmesser und der Gesamtlänge der Prüfnadel, die grundsätzlich verändert werden können, und die von der Art des Rasteradapters abhängt. Zudem ist es möglich andere Methoden der Anordnung der Prüfnadeln im Adapter zu verwenden. Die Ergebnisse dieser Beispielrechnungen können deshalb nicht ohne weiteres auf alle Leiterplattentestvorrichtungen übertragen werden. Sie dienen als Richtlinie zur Festlegung der Maße der erfindungsgemäßen Prüfnadel und zeigen, daß mit den erfindungsgemäßen Prüfnadel engste Strukturen auf einer zu prüfenden Leiterplatte abgetastet werden können.

Da die erfindungsgemäßen Prüfnadeln sich von der Kontaktspitze 4 aus konisch erweitern, ist die erfindungsgemäße Prüfnadel wesentlich steifer als Prüfnadeln, mit welchen vergleichbare Strukturen auf einer zu testenden Leiterplatte abgetastet werden können.

Die erfindungsgemäße Prüfnadel wird vorzugsweise in einem 2-stufigen Verfahren hergestellt, wobei die Prüfnadel zunächst einer Grobformung, beispielsweise mittels Schleifen, und einer Oberflächenendbearbeitung, beispielsweise durch Ätzen, unterzogen wird. Die Oberflächenendbearbeitung mittels Ätzen führt zudem zu einer Härtung der Oberfläche, wodurch die Festigkeit der Prüfnadel weiter gesteigert wird. Die Prüfnadel kann auch durch Bearbeitung mittels eines Lasers hergestellt werden. Mit einem Laser kann die Prüfnadel auch markiert werden, indem die Oberfläche oxidiert wird. Dies erlaubt die Unterscheidung von Prüfnadeln unterschiedlicher Typen. Geeignete Materialien für die Prüfnadeln sind Stahl oder harte bzw. hartelastische Legierungen, wie Titanlegierung, Nickel-Titan-Legierungen oder dergleichen.

## Patentansprüche

1. Prüfnadel für einen Rasteranpassungsadapter einer Vorrichtung zum Testen von Leiterplatten,
wobei die Prüfnadel (1) einen sich zu einer freien Kontaktspitze (4) der Prüfnadel (1) konisch verjüngend ausgebildeten Kontaktbereich (3) zum Kontaktieren eines Leiterplattentestpunktes aufweist, wobei der Kontaktbereich (3) eine Länge (L) von zumindest 15 mm und die Prüfnadel (1) an der Kontaktspitze (4) einen Durchmesser (d) von kleiner 0,2 mm besitzt, und ein der Kontaktspitze (4) gegenüberliegender Endabschnitt (5) des Kontaktbereichs (3) einen Durchmesser (D) im Bereich von 0,3 mm bis 0,4 mm aufweist.

2. Prüfnadel nach Anspruch 1,
**dadurch gekennzeichnet,**
**daß** die Länge (L) des Kontaktbereichs (3) zumindest 20 mm und der Durchmesser (D) des Endabschnittes zumindest 0,3 mm beträgt.

3. Prüfnadel nach Anspruch 1,
**dadurch gekennzeichnet,**
**daß** die Länge (L) des Kontaktbereichs (3) zumindest 30 mm und der Durchmesser (D) des Endabschnittes 0,4 mm beträgt.

4. Prüfnadel nach einem der Ansprüche 1 bis 3,
**dadurch gekennzeichnet,**
**daß** der Durchmesser (d) der Kontaktspitze (4) kleiner oder gleich 0,1 mm ist.

5. Prüfnadel nach einem der Ansprüche 1 bis 4,
**dadurch gekennzeichnet,**
**daß** die Kontaktspitze (4) abgerundet ist.

6. Prüfnadel nach einem der Ansprüche 1 bis 5,
**dadurch gekennzeichnet,**
**daß** sich an dem der Kontaktspitze gegenüberliegenden Endabschnitt ein Basisbereich (2) mit konstantem Durchmesser anschließt.

7. Prüfnadel nach Anspruch 5,
**dadurch gekennzeichnet,**
**daß** der Basisbereich (2) zumindest eine Länge von 30 mm besitzt.

8. Prüfnadel nach einem der Ansprüche 1 bis 7,
**dadurch gekennzeichnet,**
**daß** die Prüfnadel (1) durch eine Grobformung und eine Oberflächenendbearbeitung hergestellt ist.

9. Prüfnadel nach Anspruch 8,
**dadurch gekennzeichnet,**
**daß** die Grobformung Schleifen und die Oberflächenendbearbeitung Ätzen ist.

10. Prüfnadel nach einem der Ansprüche 1 bis 7,
**dadurch gekennzeichnet,**
**daß** die Prüfnadel (1) durch Bearbeitung mittels eines Lasers hergestellt ist.

11. Rasteranpassungsadapter für eine Vorrichtung zum Testen von Leiterplatten,
der mit Abstand zueinander angeordnete Führungsplatten aufweist, in welchen Führungsbohrungen zur Aufnahme von Prüfnadeln, die nach einem der Ansprüche 1 bis 10 ausgebildet sind, eingebracht sind; wobei zumindest ein Teil der Prüfnadeln im Rasteranpassungsadapter schräg zueinander angeordnet sind, so daß sie mit ihren Kontaktspitzen einen geringen Abstand aufweisen.

12. Rasteranpassungsadapter nach Anspruch 11,
**dadurch gekennzeichnet,**
**daß** der Abstand benachbarter Kontaktspitzen kleiner oder gleich 0,3 mm und vorzugsweise kleiner oder gleich 0,25 mm ist.

## Claims

1. A test needle for a pattern adapter of a circuit board tester wherein the test needle (1) comprises for contacting a circuit board test point a contact portion (3) configured conically tapered to a free contact tip (4), said contact portion (3) having a length (L) of at least 15 mm and at said contact tip (4) a diameter (d) smaller than 0.2 mm and that an end section (5) of said contact portion (3) opposite said contact tip (4) comprises a diameter (D) in the range of 0.3 mm to 0.4 mm.

2. The test needle as set forth in claim 1, **characterized in that** said length (L) of said contact portion (3) is at least 20 mm and said diameter (D) of said end section is at least 0.3 mm.

3. The test needle as set forth in claim 1, **characterized in that** said length (L) of said contact portion (3) is at least 30 mm and said diameter (D) of said end section is at least 0.4 mm.

4. The test needle as set forth in any of the claims 1 to 3, **characterized in that** the diameter (d) of said contact portion (3) is smaller than or equal to 0.1 mm.

5. The test needle as set forth in any of the claims 1 to 4, **characterized in that** said contact tip (4) is rounded.

6. The test needle as set forth in any of the claims 1 to 5, **characterized in that** adjoining said end section opposite said contact tip is a base portion (2) of constant diameter.

7. The test needle as set forth in claim 5, **characterized in that** said base portion (2) has a length of at least 30 mm.

8. The test needle as set forth in any of the claims 1 to 7, **characterized in that** said test needle (1) is made by coarse shaping and surface finishing.

9. The test needle as set forth in claim 8, **characterized in that** said coarse shaping is grinding and said surface finishing is chemical milling.

10. The test needle as set forth in any of the claims 1 to 7, **characterized in that** said test needle (1) is made by laser machining.

11. A pattern adapter for a circuit board tester comprising guide boards arranged spaced away from each other incorporatig guide holes for receiving test needles configured as set forth in any of the claims 1 to 10, wherein at least some of said test needles are arranged canted relative to each other in said pattern adapter so that they are closely spaced by their contact tips.

12. The pattern adapter as set forth in claim 11, **characterized in that** said spacing of adjoining contact tips is smaller than or equal to 0.3 mm or preferably smaller than or equal to 0.25 mm.

## Revendications

1. Aiguille de test pour adaptateur de quadrillage d'un dispositif de test de cartes de circuits imprimés, dans laquelle l'aiguille de test (1) comprend une portion de contact (3) effilée en cône en direction d'une pointe de contact libre (4) en vue de réaliser en contact avec un point de test de cartes de circuits imprimés, la portion de contact (3) ayant une longueur (L) d'au moins 15 mm et l'aiguille de test ayant au niveau de la pointe de contact (4) un diamètre (d) inférieur à 0,2 mm, et une section d'extrémité (5), opposée à la pointe de contact (4), de la portion de contact (3) a un diamètre compris entre 0,3 mm et 0,4 mm.

2. Aiguille de test selon la revendication 1, **caractérisée en ce que** la longueur (L) de la portion de contact (3) est d'au moins 20 mm et le diamètre (D) de la section d'extrémité est d'au moins 0,3 mm.

3. Aiguille de test selon la revendication 1, **caractérisée en ce que** la longueur de la portion de contact (3) est d'au moins 30 mm et le diamètre (D) de la section d'extrémité est d'au moins 0,4 mm.

4. Aiguille de test selon l'une des revendications 1 à 3, **caractérisée en ce que** le diamètre (d) de la portion de contact (3) est inférieur ou égal à 0,1 mm.

5. Aiguille de test selon l'une des revendications 1 à 4, **caractérisée en ce que** ladite pointe de contact (4) est arrondie.

6. Aiguille de test selon l'une des revendications 1 à 5, **caractérisée en ce qu'**une portion de base (2) de diamètre constant se raccorde à la section d'extrémité opposée à ladite pointe de contact.

7. Aiguille de test selon la revendication 5, **caractérisée en ce que** la portion de base (2) a une longueur d'au moins 30 mm.

8. Aiguille de test selon l'une des revendications 1 à 7, **caractérisée en ce que** l'aiguille de test (1) est réalisée par une mise en forme grossière et un finissage de surface.

9. Aiguille de test selon la revendication 8, **caractérisée en ce que** la mise en forme grossière est réalisée par polissage et la finition de surface est réalisée par attaque chimique.

10. Aiguille de test selon l'une quelconque des revendications 1 à 7, **caractérisée en ce que** l'aiguille de test (1) est réalisée par usinage au laser.

11. Adaptateur de quadrillage pour dispositif de test de cartes de circuits imprimés comprenant des cartes de guidage, espacées les unes des autres, dans lesquelles sont ménagés des perçages de guidage destinés à recevoir des aiguilles de test qui sont conformées selon l'une quelconque des revendications 1 à 10, au moins une partie des aiguilles de test étant disposées inclinées les unes par rapport aux autres dans ledit adaptateur de quadrillage de sorte qu'elles sont étroitement espacées au niveau de leurs pointes de contact.

12. Adaptateur de quadrillage selon la revendication 11, **caractérisé en ce que** l'écartement des pointes de contact adjacentes est inférieur ou égal à 0,3 mm ou de préférence inférieur ou égal à 0,25 mm.
